# EUROPEAN PATENT APPLICATION

(11) **EP 3 770 298 A1**
(43) Date of publication of application: **27.01.2021**
(21) Application number: 19188069.9
(22) Date of filing: 24.07.2019
(51) Int. Cl.: C23C 18/52, H01L 23/00

(54) **TIN PLATING BATH AND A METHOD FOR DEPOSITING TIN OR TIN ALLOY ONTO A SURFACE OF A SUBSTRATE**

(71) Applicant: Atotech Deutschland GmbH, 10553 Berlin (DE)
(72) Inventor: Tuna, Kadir, 10553 Berlin (DE)
(74) Representative: Atotech Deutschland GmbH

(57) **Abstract**

The present invention concerns a tin plating bath comprising tin ions; titanium ions as reducing agent suitable to reduce tin ions to metallic tin; and at least one compound selected from the group consisting sulfites, dithionites, thiosulfates, tetrathionates, polythionates, disulfites, sulfides, disulfide, polysulfide, elemental sulfur or mixtures thereof. The present invention further discloses a method of depositing tin or a tin alloy onto a surface of a substrate. The tin plating bath is particularly suitable to be used in the electronics and semiconductor industry.

## Description

### Field of the Invention

The present invention relates to a tin plating bath comprising tin ions and titanium ions as reducing agent suitable to reduce tin ions to metallic tin. The present invention further relates to a method of depositing tin or a tin alloy onto a surface of a substrate. The tin plating bath is particularly suitable to be used for depositing tin or tin alloy onto at least one surface of a substrate, preferably in the electronics and semiconductor industry.

### Background of the Invention

Deposits of tin and tin alloys on electronic parts such as printed circuit boards, IC substrates and semiconductor wafers are used *inter alia* as solderable and bondable finishes in later manufacturing steps of such electronic parts.

The tin and tin alloy deposits are usually formed on metallic contact areas such as contact pads and bump structures. The contact areas are usually made of copper or copper alloys. In case such contact pads can be electrically contacted for deposition of tin and tin alloy layers such layers are deposited by conventional electroplating methods. However, in many cases the individual contact areas cannot be electrically contacted. In such cases an electroless plating method needs to be applied. The method of choice in the industry for electroless plating of tin and tin alloy layers used to be immersion plating. The main disadvantage of immersion type plating is the limited thickness of the tin or tin alloy deposit. Immersion plating is based on an exchange between tin ions and the metallic copper contact area to be plated. With immersion type plating of tin or tin alloy layers the deposition rate decreases strongly with increasing tin layer thickness, since the exchange of copper against tin is hindered by the growing tin layer.

In situations where a thicker layer of tin or a tin alloy layer is desired and an electrical connection cannot be provided, an autocatalytic type electroless plating process is required. Plating bath compositions for autocatalytic plating of tin or tin alloys comprise a (chemical) reducing agent.

US 2005/077186 A1 discloses an acidic electrolytic tin plating bath comprising an aliphatic complexant having a sulfide group and an amino group which are linked to different carbon atoms. Also, such sulfur compounds are used in electrolytic bronze plating (DE 10 2013 226 297 B3 and EP 1 001 054 A2) and electrolytic tin plating as described in CN 1804142 A as well as CN 103173807 A.

WO 2009/157334 A1 relates to electroless tin plating baths comprising organic complexing agents and organic sulfides. However, the plating baths disclosed show a quick loss of plating rate over time and results in low overall plating rates (see comparative examples of WO 2018/122058 A1).

This is a major drawback of many tin plating baths, in particular electroless tin plating baths, known in the art.

US 8,801,844 B2 relates to an autocatalytic tin plating bath composition comprising a water-soluble source of Sn²⁺ ions, a water-soluble source of Ti³⁺ ions, and 1,10-phenanthroline and/or at least one 1,10-phenanthroline derivative as a stabilizing additive.

Typically, conventional tin plating baths show a plating behavior that starts with a very high plating rate which then decreases significantly over time of use. In some cases, the plating rates gives a sharp peak within the first minutes to then drop all the quicker. Such behavior is highly undesired as it makes it very difficult to control the plating outcome such as tin deposit homogeneity and thickness.

### Objective of the present Invention

It is therefore an objective of the present invention to overcome the shortcomings of the prior art. It is another objective to provide a tin plating bath having an improved plating rate compared to electroless tin plating baths known from the prior art.

It is a further objective to provide a tin plating bath having a constant plating rate over time.

It is a further objective to provide a tin plating bath (sufficiently) stable against plate-out (e.g. for at least 4 h after make-up or during use).

It is a further objective to reduce the number of compounds and/or to reduce the number of compounds in the tin plating bath.

### Summary of the Invention

Above-named objectives are solved by an electroless tin plating bath comprising
(a) tin ions;
(b) titanium ions as reducing agent suitable to reduce tin ions to metallic tin;
(c) at least one accelerator selected from the group consisting of sulfites, dithionites, thiosulfates, tetrathionates, polythionates, disulfites, sulfides, disulfide, polysulfide, elemental sulfur and mixtures thereof;
(d) at least one complexing agent; and
(e) optionally at least one hypophosphite,
wherein the pH value of the tin plating bath is from 5 to 10.5 with the proviso if thiosulfates are comprised in the tin plating bath the pH upper value is lower than 9.5.

Above-named objectives are further solved by the use of the tin plating bath according to the invention for depositing tin or tin alloy onto at least one surface of a substrate (preferably in the electronics and semiconductor industry) and the method for depositing tin or tin alloy onto at least one surface of at least one substrate comprising the method steps
(i) providing the substrate; and
(ii) contacting at least one surface of the substrate with the inventive tin plating bath according to the invention such that a tin or tin alloy is deposited on the at least one surface of the substrate.

As shown in the examples below it has surprisingly been found that with tin plating baths according to the present invention significantly higher plating rates can be achieved (see e.g. inventive examples 1 to 10 compared to comparative examples C1 and C2).

Advantageously, the inventive tin plating baths show no or a minimal loss of plating rate over time. Even after several hours of use of the inventive tin plating baths, a high and constant plating rate can be observed after inserting new (or rinsed) substrates into the tin plating baths. Own investigations have found that the inventive tin plating baths can be used for many hours (partially more than eight hours) without to show plate-out and with a high and constant plating rate during the whole time. Further, the inventive tin plating bath allows for homogeneous tin or tin alloy deposits to be formed. There is no or very little dependence of the layer thickness of the tin or tin alloy deposits if two or more surfaces of different size areas are plated simultaneously. When using conventional plating baths to deposit tin simultaneously on substrates with different size areas, the plating typically results in inhomogeneously covered surfaces (in particular in terms of tin or tin alloy deposit thickness). The disadvantage of conventional tin plating baths that, typically, larger surface areas resulted in thinner deposits compared to smaller surface areas has been overcome by the present invention.

It is yet another advantage of the present invention that the tin plating baths according to the present invention show a sufficiently initial high plating rate (e.g. after 5 min) and a sufficiently high plating rate during use.

It is another advantage of the present invention that glossy tin deposits can be provided, without the need of an organic gloss agent or a surfactant. The tin deposits are further free of visible detectable defects such as burnings or blisters.

### Detailed Description of the Invention

Advantageously, the inventive tin plating bath has a loss of plating rate over time which is minimized compared to a conventional tin plating bath known in the art. Ideally, the inventive tin plating bath allows for a constant plating rate, at least for a certain period of time.

A tin plating bath whose loss of plating rate over time is minimized, and ideally a tin plating bath with constant plating rate, allows for improved process control as the tin deposit thickness can easily be controlled. This eliminates the necessity of tedious optimizations if the deposition of certain tin deposit thicknesses is desired. Further, tin deposits formed at a constant plating rate are much more homogeneous (in particular in terms of tin or tin alloy deposit thickness) compared to deposits from plating baths with varying plating rates. It is thus highly desired to provide a tin plating bath with a constant plating rate.

The inventive tin plating bath comprises tin ions. Typical sources of the tin ions are water-soluble tin salts or water-soluble tin complexes. Preferably, the tin ions are tin (II) ions facilitating the reduction to their metallic state (compared to tin(IV) ions). More preferably, the at least one source of the tin ions is selected from the group consisting of organic sulfonates of tin in the oxidation state +II such as tin (II) methane sulfonate; tin (II) sulfate; tin (II) halides such as tin (II) chloride, tin (II) bromide; tin (II) pyrophosphate; linear tin (II) polyphosphate; cyclic tin (II) polyphosphate and mixtures of the aforementioned. Even more preferably, the at least one source of the tin ions is selected from the group consisting of tin (II) chloride, tin (II) pyrophosphate, linear tin (II) polyphosphate, cyclic tin (II) polyphosphate and mixtures of the aforementioned to avoid undesired further anions in the tin or tin alloy plating. Alternatively and preferably, the tin ions can be prepared by anodic dissolution of metallic tin.

The total concentration of tin ions in the inventive tin plating bath preferably ranges from 0.02 to 0.2 mol/L, more preferably from 0.04 to 0.15 mol/L and even more preferably from 0.05 to 0.08 mol/L. Concentrations outside above thresholds are applicable depending on the circumstances. However, if the concentrations are below said thresholds longer plating times may be required and concentrations above said thresholds in some case may lead to plate-out.

The inventive electroless tin plating bath thus comprises titanium ions suitable to reduce tin ions to metallic tin. Titanium (III) ions are used as the at least one reducing agent. Titanium (III) ions may be added as water-soluble titanium (III) compounds. The preferred titanium (III) compounds are selected from the group consisting of titanium (III) chloride, titanium (III) sulfate, titanium (III) iodide, and titanium (III) methane sulfonate. Alternatively, the inventive tin plating bath can be made up with a source of titanium (IV) ions or a mixture of titanium (III) and titanium (IV) ions and activated before use by electrochemically reducing the titanium (IV) ions to titanium (III) ions as described in US 6,338,787. In particular, a regeneration cell as described in WO 2013/182478 A2, e.g. in figure 1 therein, and the method described by said document are also useful for this purpose.

The total concentration of all titanium (III) ions in the inventive electroless tin plating bath preferably ranges from 0.02 mol/L to 0.2 mol/L, more preferably from 0.04 mol/L to 0.15 mol/L and even more preferably from 0.05 to 0.08 mol/L.

The inventive electroless tin plating bath thus comprises at least one accelerator selected from the group consisting of sulfites, dithionites, thiosulfates, tetrathionates, polythionates, disulfites, sulfides, disulfide, polysulfide, elemental sulfur and mixtures thereof. Own research has shown that a) sulfite and/or b) a dithionite, c) thiosulfate, d) tetrathionate, e) polythionate, f) disulfite, g) elemental sulfur and/or h) sulfide, disulfide, polysulfide serves as accelerators to improve the tin plating rate. Preferable sources of sulfites, dithionites, thiosulfates, tetrathionates, polythionates, sulfide, disulfide, polysulfide and disulfites are the respective salts such as alkaline salts (e.g. sodium sulfite, potassium sulfite, sodium bisulfite), earth alkaline metal salts (e.g. magnesium sulfite, calcium sulfite), ammonium salts and mixtures of the aforementioned. Preferably the at least one accelerator is water soluble and the used counter ions as sodium or potassium will not co-deposited.

For the present invention, the term polythionates refers to oxoanions with the formula Sₙ(SO₃)₂²⁻ with n = 0, 1, 3, 4, 5, 6, 7 or ≥ 8.

Dithionites, thiosulfates, tetrathionates, polythionates, disulfites, disulfide, polysulfide, and elemental sulfur are compounds containing at least one S-S moiety.

A tin plating bath according to the present invention is preferred, wherein the accelerator(s) is/are selected from the group consisting of alkaline metal sulfites, alkaline metal hydrogen sulfites, alkaline earth metal sulfites, alkaline earth metal hydrogen sulfites, ammonium sulfite, ammonium hydrogen sulfite, alkaline metal dithionites, alkaline metal hydrogen dithionites, alkaline earth metal dithionites, alkaline earth metal hydrogen dithionites, alkaline metal thiosulfates, alkaline metal hydrogen thiosulfates, alkaline earth metal thiosulfates, alkaline earth metal hydrogen thiosulfates, ammonium thiosulfate, ammonium hydrogen thiosulfate, alkaline metal tetrathionates, alkaline metal hydrogen tetrathionates, alkaline earth metal tetrathionates, alkaline earth metal hydrogen tetrathionates, ammonium tetrathionates, ammonium hydrogen tetrathionate, alkaline metal polythionates, alkaline metal hydrogen polythionates, alkaline earth metal polythionates, alkaline earth metal hydrogen polythionates, ammonium polythionates, ammonium hydrogen polythionate, alkaline metal disulfites, alkaline metal hydrogen disulfites, alkaline earth metal disulfites, alkaline earth metal hydrogen disulfites, ammonium disulfites, ammonium hydrogen disulfite, alkaline metal sulfide, alkaline metal disulfide, alkaline metal polysulfide, ammonium sulfide and cyclo-octasulfur (S8).

A tin plating bath according to the present invention is further preferred, wherein the accelerator(s) is/are selected from the group consisting of sodium sulfite, potassium sulfite, sodium hydrogen sulfite (sodium bisulfite), potassium hydrogen sulfite (potassium bisulfite), calcium dihydrogen disulfit (calcium bisulfite), magnesium dihydrogen disulfit (magnesium bisulfite), ammonium sulfite, ammonium hydrogen sulfite, sodium dithionite, potassium dithionite, calcium dithionite, magnesium dithionite, sodium thiosulfate, sodium hydrogen thiosulfate, potassium thiosulfate, calcium thiosulfate, potassium thiosulfate, barium thiosulfate, ammonium thiosulfate, ammonium hydrogen thiosulfate, sodium tetrathionate, potassium tetrathionate, ammonium tetrathionate, ammonium hydrogen tetrathionate, barium tetrathionate, sodium polythionate, potassium polythionate, ammonium polythionate, ammonium hydrogen polythionate, sodium disulfite, potassium disulfite, ammonium disulfite, ammonium hydrogen disulfite, sodium or potassium sulfide, sodium or potassium disulfide, sodium or potassium polysulfide, ammonium sulfide and particulate cyclo-octasulfur (S₈).

In one embodiment, if the selected accelerators comprise inorganic sulfides as alkaline metal sulfide, the at least one pH adjuster is selected from the group consisting of ammonia or an inorganic ammonia derivate as ammonium hydroxide, ammonium chloride.

Sodium dithionite and/or sodium sulfite and/or sodium thiosulfate and/or sodium tetrathionate and/or sodium polythionate and/or sodium disulfite are used particularly preferably according to the invention. In case elemental sulfur is used in tin plating baths according to the present invention, it is preferred that sulfur in its cyclo-S₈ configuration is used. It is particularly preferred that the sulfur is present as sulfur particles, especially sulfur particles with an aerodynamic diameter determined via an aerodynamic particle sizer (APS) below 300 nm, preferably below 200 nm, more preferably below 100 nm. Although not wishing to be bound to any particular theory, it is believed sulfur converts to two different compounds, namely sulfite and sulfide.

Preferably, the molar ratio of all the accelerators used according to the present invention to the tin ions is at least 1 to 300. More preferably, the molar ratio of all accelerators used according to the present invention to the tin ions ranges from 1 : 200 to 1 : 5.000, even more preferably from 1 : 300 to 1 : 4.000, still even more preferably 1 : 500 to 1 : 1.500, most preferably from 1 : 550 to 1 : 1.000.

The total concentration of sulfites, dithionites, thiosulfates, tetrathionates, polythionates, disulfites, sulfides, disulfide, polysulfide and sulfur in the inventive electroless tin plating bath preferably ranges from 0.0008 to 0.80 mmol/L, more preferably from 0.008 to 0.40 mmol/L and even more preferably from 0.04 to 0.16 mmol/L.

Preferably, the inventive tin plating bath is free of organic sulfites. The inventors have found that these compounds occasionally have a negative influence on the plating rate and increase the loss of plating rate over time and during use of a tin plating bath containing such organic sulfites.

An electroless tin plating bath according to the invention is preferred comprising tin (II) chloride, titanium (III) chloride and at least one accelerator selected from the group consisting of sodium sulfite, sodium dithionite, sodium thiosulfate and mixtures thereof.

The inventive tin plating bath further comprises (d) at least one complexing agent (also referred to as chelating agent in the art), preferably selected from the group consisting of
- organic polycarboxylic acids, their salts, anhydrides and esters,
- organic phosphonic acids, their salts and esters,
- organic polyphosphoric acids, their salts and esters, and
- inorganic polyphosphoric acids, their salts and esters.

In the context of the present invention, organic polycarboxylic acids are organic compounds having multiple (at least two) carboxylic acid functional groups. A tin plating bath according to the present invention is further preferred, wherein the organic polycarboxylic acids, their salts, anhydrides and esters, are selected from the group consisting of oxalic acid, tartaric acid, citric acid, nitrilotriacetic acid, ethylenediaminetetraacetic acid, dimercaptosuccinic acid, 1,4,7,10-tetraazacyclododecane-1,4,7,10-tetraacetic acid, 3,6,9,12-Tetrakis(carboxymethyl)-3,6,9,12-tetraazatetradecane-1,14-dioic acid, pentetic acid, iminodiacetic acid, diethylenetriamine, aminoethylethanolamine, and salts, anhydrides or esters thereof.

Preferred salts of the organic polycarboxylic acids according to the invention are alkaline or earth alkaline metal salts of the organic polycarboxylic acids (e.g. lithium, sodium, potassium, magnesium, calcium, beryllium) or ammonium salts of the organic polycarboxylic acids. Preferred esters of the organic polycarboxylic acids according to the invention are methyl, ethyl, propyl, isopropyl, butyl, pentyl, octyl, decyl and dodecyl esters or the organic polycarboxylic acids.

Preferred salts or anhydrides of citric acid (citrates) according to the invention are alkaline, earth alkaline metal or ammonium salts of citric acid (e.g. sodium citrate, potassium citrate, magnesium citrate), and citric acid anhydride.

Preferred salts or anhydrides of nitrilotriacetic acid according to the invention are nitrilotriacetic acid anhydrides and alkaline, earth alkaline metal or ammonium salts of nitrilotriacetic acid (e.g. (mono, di or tri) sodium nitrilotriacetic acid, (mono, di or tri) potassium nitrilotriacetic acid, magnesium nitrilotriacetic acid).

A tin plating bath according to the present invention is further preferred, wherein the organic phosphonic acids, their salts and esters, are selected from the group consisting of 1-hydroxyethane 1,1-diphosphonic acid (HEDP, CAS No. 2809-21-4), its salts and esters, ami-notris(methylenephosphonic acid) (ATMP, CAS No. 6419-19-8), its salts and esters, diethylenetriamine penta(methylene phosphonic acid) (DTPMP, CAS No. of sodium salt: 22042-96-2), its salts and esters, ethylenediamine tetra(methylenephosphonic acid) (EDTMP, CAS No. of sodium salt: 15142-96-8), its salts and esters, phosphonobutane tricarboxylic acid (PBTC, CAS No. 37971-36-1), its salts and esters, hexanediamine tetra(methylenephosphonic acid) (HDTMP, CAS No. 23605-74-5), its salts and esters, hydroxyethylamino di(methylenephosphonic acid) (HDTMP, CAS No. 23605-74-5), its salts and esters, and bis(hexamethylene) triamine-pentakis(methylphosphonic acid) (BHMTMP, CAS No. 34690-00-1), its salts and esters.

Preferred salts of the organic phosphonic acids according to the invention are alkaline or earth alkaline metal salts of the organic phosphonic acids (e.g. lithium, sodium, potassium, magnesium, calcium, beryllium) or ammonium salts of the organic phosphonic acids. Preferred esters of the organic phosphonic acids according to the invention are methyl, ethyl, propyl, isopropyl, butyl, pentyl, octyl, decyl and dodecyl esters or the organic phosphonic acids.

A tin plating bath according to the present invention is further preferred, wherein the inorganic polyphosphoric acids, their salts and esters, are linear or cyclic, more preferably are selected from the group consisting of potassium pyrophosphate, sodium pyrophosphate, and hydrogen sodium pyrophosphate. Potassium pyrophosphate is used particularly preferably according to the invention.

A tin plating bath according to the present invention is further preferred, wherein the organic and/or inorganic polyphosphoric acids, their salts and esters, comprise 2 to 10 phospho-building units linked together, preferably 2 to 5, more preferably 2 or 3.

Mixtures of two or more of said complexing agents may suitably be used.

The total concentration of all complexing agents in the inventive tin plating bath preferably ranges from 0.1 to 3.5 mol/L, more preferably from 0.1 to 2 mol/L and even more preferably from 0.15 to 1.5 mol/L, yet even more preferably from 0.2 to 1.2 mol/L and still more preferred from 0.25 to 1.0 mol/L and most preferred from 0.5 to 1.0 mol/L. Concentrations outside above thresholds are applicable depending on the particular circumstances. However, if the concentrations are below said thresholds the stability of the inventive tin plating bath may be insufficient resulting in plate-out and concentrations above said thresholds in some cases may lower the plating rate of the inventive tin plating bath. Complexing agents fulfill various functions in the inventive tin plating bath. They firstly exert a buffering action of the pH of the bath. Secondly, they prevent the precipitation of the tin ions and thirdly, reduce the concentration of free (i.e. tin ions which are not complexed) tin ions. In particular, because of the two last named reasons, it is a preferred embodiment of the present invention, that the at least one complexing agent is used in a molar excess with respect to the tin ions.

Preferably, the molar ratio of all the complexing agents used according to the present invention to the tin ions is at least 1 to 1. More preferably, the molar ratio of all complexing agents used according to the present invention to the tin ions ranges from 2/1 to 25/1, even more preferably from 2.5 to 20/1, still even more preferably 5/1 to 15/1, most preferably from 7.5/1 to 12.5/1.

Preferably, the inventive tin plating bath is free of 1,10-phenanthroline and/or 1,10-phenanthroline derivatives (including dibenzo[b,j][1,10]phenanthroline and dibenzo[b,j][1,10]phenanthroline derivatives). The inventors have found that these compounds occasionally may have a negative influence on the plating rate and increase the loss of plating rate over time and during use of a tin plating bath containing such compounds.

Optionally, the inventive electroless tin plating bath comprises (e) at least one hypophosphite. Although not wishing to be bound to any particular theory, it is believed that hypophosphite acts as antioxidants which inhibits the oxidation of tin (II) ions to tin (IV) ions. Hypophosphites are a class of phosphorus compounds conceptually based on the structure of hypophosphorous acid (H₃PO₂). In this text the term hypophosphite is used to describe inorganic species (e.g. sodium hypophosphite or potassium hypophosphite) and the organophosphorus species. The preferred hypophosphites are selected from the group consisting of alkaline or earth alkaline metal hypophosphites (e.g. lithium, sodium, potassium, magnesium, calcium, beryllium) and ammonium hypophosphite, more preferably sodium hypophosphite, potassium hypophosphite, and ammonium hypophosphite. Sodium hypophosphite is used particularly preferably according to the invention.

The total concentration of all hypophosphites in the inventive electroless tin plating bath preferably ranges from 1 to 570 mmol/L, more preferably from 10 to 230 mmol/L and even more preferably from 30 to 170 mmol/L. Concentrations outside above thresholds are applicable depending on the circumstances. However, if the concentrations are below said thresholds the antioxidant effect is reduced, and concentrations above said thresholds in some case may lead to plate-out.

Optionally, the inventive tin plating bath comprises (additionally) at least one antioxidant which is not a hypophosphite. The at least one additional antioxidant advantageously inhibits the oxidation of tin (II) ions to tin (IV) ions. The at least one additional antioxidant is preferably a hydroxylated aromatic compound such as catechol, resorcinol, hydroquinone, pyrogallol, α- or β-naphthol, phloroglucinol or a sugar-based compound such as ascorbic acid and sorbitol. Said antioxidants are typically used in a total concentration of 0.1 to 1 g/L.

Optionally, the inventive tin plating bath further comprises (f) at least one stabilizing additive selected from the group consisting of 2-mercaptopyridine, 2-mercaptobenzothiazole, 2-mercapto-2-thiazoline and mixtures of the aforementioned.

The total concentration of all stabilizing additives in the inventive tin plating bath preferably ranges from 0.5 to 200 mmol/L, more preferably from 1 to 100 mmol/L, even more preferably from 5 to 30 mmol/L and yet even more preferably from 6 to 25 mmol/L. Concentrations outside above thresholds are applicable depending on the circumstances. However, if the concentrations are below said thresholds the positive effects of the present invention may not be pronounced enough, and concentrations above said thresholds in some case do not add further to the benefits while only increasing the cost.

The inventors have surprisingly found that the combination of above complexing agents with the stabilizing additives described hereinbefore allow for the beneficial effects described in this specification such as maintenance of the plating rate of the inventive tin plating bath during use and over time.

The inventive tin plating bath is an electroless (autocatalytic) tin plating bath. The terms "electroless tin plating bath" and "autocatalytic tin plating bath" are used interchangeably herein. In the context of the present invention, electroless plating is to be understood as autocatalytic deposition with the aid of a (chemical) reducing agent (referred to as "reducing agent" herein). It is to be distinguished between electroless and immersion plating baths. The latter do not require the addition of a (chemical) reducing agent but rely on the exchange of metal ions in the bath with metallic components from the substrate, e.g. copper (*vide supra*). There is thus a fundamental difference between those two types of plating baths.

The inventive tin plating bath is an aqueous solution. This means that the prevailing solvent is water. Other solvents which are miscible with water such as polar organic solvents including alcohols, glycols and glycol ethers are optionally added. For its ecologically benign characteristics, it is preferred to use water only (*i.e.* more than 99 wt.-% based on all solvents, more preferably more than 99.9 wt.-% based on all solvents).

The pH value of the inventive tin plating bath preferably ranges from 5 to 9, more preferably from 6 to 8.5 and even more preferably from 6.4 to 8.3. These pH ranges allow for stable tin plating baths with improved maintenance of the plating rate or, ideally, with constant plating rates.

If thiosulfates are comprised in the inventive tin plating bath the pH value of the of the inventive tin plating bath is lower than 9.5, preferably ranges from 5 to 9.5, more preferably ranges from 6 to 9, more preferably from 6.4 to 8.5 and even more preferably from 8.0 to 8.3.

Optionally, the inventive tin plating bath comprises at least one pH adjustor. Said pH adjustor is an acid, a base or a buffer compound. Preferable acids are selected from the group consisting of inorganic acids and organic acids. Inorganic acids are preferably selected from the group consisting of phosphoric acid, hydrochloric acid, sulfuric acid, nitric acid, and mixtures of the aforementioned. Organic acids are typically carboxylic acids such as formic acid, acetic acid, malic acid, lactic acid and the like and mixtures of the aforementioned. Preferable bases are selected from the group consisting of inorganic bases and organic bases. Inorganic bases are preferably selected from the group consisting of ammonia, potassium hydroxide, sodium hydroxide, Calcium hydroxide and mixtures of the aforementioned, more preferably selected from the group consisting of ammonia and sodium hydroxide. Organic bases are typically amines such as ethylendiamin, methylamine, dimethylamine, trimethylamine, ethylamine, propylamine, triethylamine, aniline, pyride, and the like and mixtures of the aforementioned. Buffer compounds are preferably boric acid and/or phosphate based buffers. The at least one pH adjustor is typically used in concentrations to adjust the pH value of the inventive tin plating bath to said ranges.

In one embodiment the at least one pH adjuster is selected from a group consisting of ammonia or an inorganic ammonia derivate as ammonium hydroxide, ammonium chloride, ammonium acetate. It could be found, that these pH adjuster also show good stabilizing properties for at least 3 - 9 hours, preferably for 4 - 8 hours, more preferably for 6 - 8 hours and plating out during this time was avoided.Optionally, the inventive tin plating bath comprises at least one further type of reducible metal ions other than tin ions. The term "reducible metal ions" is to be understood in the context of the present invention as metal ions which can be reduced to their respective metallic state under the given conditions (e.g. typical plating conditions and in particular the conditions outlined in this specification). Exemplarily, alkaline metal ions and earth alkaline metal ions typically cannot be reduced to their respective metallic state under the conditions applied. If such further type of reducible metal ions other than tin ions is present in the tin plating bath, a tin alloy will be deposited when using the inventive tin plating bath. Typical tin alloys used as solderable or bondable finishes on contact areas are tin-silver alloys, tin-bismuth alloys, tin-nickel alloys and tin-copper alloys. Suitable further types of reducible metal ions other than tin ions are thus preferably selected from the group consisting of silver ions, copper ions, bismuth ions and nickel ions.

A source of optional silver ions, bismuth ions, copper ions and nickel ions is selected from water-soluble silver, bismuth, copper and nickel compounds. The preferred water-soluble silver compound is selected from the group consisting of silver nitrate, silver sulfate, silver oxide, silver acetate, silver citrate, silver lactate, silver phosphate, silver pyrophosphate and silver methane sulfonate. The preferred water-soluble bismuth compound is selected from the group consisting of bismuth nitrate, bismuth oxide, bismuth methane sulfonate, bismuth acetate, bismuth carbonate, bismuth chloride and bismuth citrate. The preferred water-soluble copper compound is selected from the group consisting of copper sulfate, copper alkylsulfonate such as copper methane sulfonate, copper halides such as copper chloride, copper oxide and copper carbonate. The preferred source of water-soluble nickel compound is selected from the group consisting of nickel chloride, nickel sulfate, nickel acetate, nickel citrate, nickel phosphate, nickel pyrophosphate and nickel methane sulfonate.

The concentration of the at least one further type of reducible metal ions other than tin ions preferably ranges from 0.01 g/L to 10 g/L, more preferably from 0.02 g/L to 5 g/L.

In one embodiment of the present invention, the inventive tin plating bath is substantially free of further reducible metal ions other than tin ions. This means that the amount of further reducible metal ions is 1 mol-% or less based on the amount of tin ions. Preferably, only tin ions as reducible metal ions are present in the tin plating bath. Then, pure tin will be deposited by using the tin plating bath.

In some embodiments of the present invention, the inventive tin plating bath is free of organophosphorus such as organophosphinates or organophosphorus compounds such as nitrilot-ris(methylene phophonate) (NTMP), particularly of organophosphorus compounds wherein the phosphorus atoms in said compounds are in the oxidation state +III. The inventors have found that these compounds occasionally may have a negative influence on the plating rate and increase the loss of plating rate over time and during use of a tin plating bath containing such organophosphorus compounds.

Preferably, the inventive tin plating bath preferably is free of thiourea because of its acute toxicity and its tendency to dissolve metals ions from a metallic surface, e.g. copper ions from a cuprous surface. Thiourea further increases the loss of plating rate over time and during use of a tin plating bath containing said compound.

Preferably, the inventive tin plating bath preferably is free of cyanide ions (CN⁻) because of the toxicity thereof. In one embodiment of the present invention, the inventive tin plating bath comprises only complexing agents selected from the group consisting of pyrophosphate ions, linear polyphosphate ions and cyclic polyphosphate ions.

Preferably, the inventive tin plating bath preferably is free of polysulfides such as alkaline polysulfides to avoid hydrogensulfide liberation.

Optionally, the inventive tin plating bath comprises at least one surfactant. The at least one surfactant improves the wetting of the substrate with the inventive tin plating bath and thus facilitates the tin deposition. It further helps to deposit smooth tin deposits. Useful surfactants can be determined by the person skilled in the art by routine experiments. Said surfactants are typically used in a total concentration of 0.01 to 20 g/L.

The inventive tin plating bath may be prepared by dissolving all components in at least one solvent, preferably in water for the reasons outlined hereinbefore. An alternative preparation method which is particularly useful is as follows:
Firstly, a solution of tin (II) ions and complexing agent in a solvent is prepared, preferably in water. Secondly, a solution comprising complexing agent and titanium (IV) salts, typically titanium (IV) alkoxylates because of their solubility, is acidified with an (preferably inorganic) acid such as phosphoric acid. Said solution is then subjected to elevated temperatures to remove all volatile components such as alcohols and the like. A subsequent reduction, preferably electrolytically using a constant cathodic current, of the titanium (IV) ions to titanium (III) ions is followed by mixing the two aforementioned solutions and addition of the further components such as the stabilizing additives.

In method step (i) of the method according to the invention the substrate is provided. The substrate has at least one surface suitable to be treated with the inventive tin plating bath. Preferably, said at least one surface is selected from surfaces comprising copper, nickel, cobalt, gold, palladium, tungsten, tantalum, titanium, platinum alloys and mixtures of any of the aforementioned. The surfaces consist of the aforementioned materials or only comprise the aforementioned, preferably in an amount of at least 50 wt.-%, more preferably of at least 90 wt.-%. The substrates are made in their entirety of the materials listed above or they only comprise one or more surfaces made of the materials listed above. It is also possible within the meaning of the present invention to treat more than one surface simultaneously or subsequently.

More preferably, the at least one surface is selected from the group consisting of surfaces comprising (or consisting of) copper, nickel, cobalt, gold, palladium, platinum, alloys and mixtures of any of the aforementioned.

In particular, substrates typically employed in the electronics and semiconductor industry having one or more of above-described surfaces are used in the method according to the invention. Such substrates include *inter alia* printed circuit boards, IC substrates, flat panel displays, wafers, interconnect devices, ball grid arrays and the like.

Optionally, the at least one substrate is subjected to one or more pre-treatment steps. Pre-treatment steps are known in the art. The pre-treatment steps can be for example cleaning steps, etching steps and activation steps. Cleaning steps typically use aqueous solutions comprising one or more surfactants and are used to remove contaminants, e.g. from the at least one surface of the at least one substrate which are detrimental to the tin plating deposition. Etching steps usually employ acidic solutions, optionally comprising one or more oxidant such as hydrogen peroxide, to increase the surface area of the at least one surface of the at least one substrate. Activation steps usually require the deposition of a noble metal catalyst, most often palladium, on the at least one surface of the at least one substrate to render said at least one surface more receptive for tin deposition. Sometimes an activation step is preceded by a pre-dip step or succeeded by a post-dip step, both which are known in the art.

In method step (ii) of the method according to the invention, the at least one surface to be treated of the substrate is contacted with the inventive tin plating bath. By contacting the at least one surface of the substrate with the inventive tin plating bath, tin or a tin alloy is deposited on the at least one surface of the at least one substrate.

The inventive tin plating bath is preferably contacted to the respective surface by immersion, dip-coating, spin-coating, spray-coating, curtain-coating, rolling, printing, screen printing, ink-jet printing or brushing. In one embodiment of the present invention, the inventive tin plating bath is used in horizontal or vertical plating equipment.

The contacting time of the at least one surface with the inventive tin plating bath preferably ranges from 1 min to 4 h, more preferably from 15 min to 2 h and even more preferred from 30 min to 1h. Contacting times outside above thresholds are possible if particularly thin or thick tin or tin alloys deposits are required. The preferred thickness of the tin or tin alloy deposit ranges from 1 to 30 µm, preferably from 2 to 20 µm and more preferably from 4 to 10µm.

The tin plating rate controlling the tin layer thickness of the at least one surface according to time increases with the inventive tin plating bath to preferably more than 4 µm per hour, more preferably more than 5 µm per hour, even more preferably more than 6 µm per hour. A plating rate of at least 2 µm/h is usually required for practical applications. It could be shown that with the inventive tin plating bath, the value of the plating rate from preferably 2 to 6 µm per hour or more, preferably from 3 to 5 µm per hour, is maintained over the used plating time (time were the at least one surface of the substrate is in contact with the tin plating bath - plating time).

With other words, the tin plating baths according to the present invention show not even an initial high plating rate of 2 to 6 µm per hour or more, preferably from 3 to 5 µm per hour and also a high plating rate during use. The plating rate is preferably in the range from 2 to 6 µm per hour over at least two hours of use (plating time), more preferred in the range from 3 to 6 µm per hour over at least one hour of use (plating time). In any case the plating rate preferably does not fall under 2 µm per hour over the used plating time, preferably not under 3 µm per hour at least for two hours.

The application temperature depends on the method of application used. For example, for dip, roller or spin coating applications, the temperature of application typically ranges between 40 and 90 °C, preferably between 50 and 85 °C and even more preferred between 65 and 75 °C.

Optionally, the inventive tin plating bath may be regenerated. Regeneration of the tin plating bath is exemplarily used to reduce the titanium (IV) ions to the titanium (III) ions. A useful method and a suitable apparatus for this purpose are described *inter alia* in EP 2 671 968 A1.

The components in the inventive tin plating bath may optionally be replenished, e.g. by anodic dissolution of metallic tin or by addition of above-named components either as such or in solution.

Optionally, the tin or tin alloy deposit is post-treated with an anti-tarnish composition which is known in the art.

The inventive method optionally comprises one or more rinsing steps. Rinsing can be accomplished by treatment of the at least one surface of the at least one substrate with at least one solvent, said at least one solvent optionally comprising one or more surfactants. The at least one solvent is preferably selected from the group consisting of water, more preferably deionized water (DI water), alcohols such as ethanol and iso-propanol, glycols such as DEG and glycol ethers such as BDG and mixtures of the aforementioned.

The inventive method optionally further comprises drying steps. Drying can be done by any means known in the art such as subjecting the substrate to elevated temperature and/or air drying.

The present invention further concerns products manufactured with the inventive method or with the inventive tin plating bath. In particular, it concerns printed circuit boards, IC substrates, flat panel displays, wafers, interconnect devices, ball grid arrays comprising at least one tin or tin alloy deposit formed with the inventive tin plating bath and/or the inventive method.

Percentages throughout this specification are weight-percentages (wt.-%) unless stated otherwise. Yields are given as percentage of the theoretical yield. Concentrations given in this specification refer to the volume or mass of the entire solutions unless stated otherwise.

The terms "deposition" and "plating" are used interchangeably herein.

The invention will now be illustrated by reference to the following non-limiting examples.

### Examples

Products were used (concentrations, parameters, further derivatives) as described in the corresponding technical datasheets (as available at the date of filing) unless specified differently hereinafter. A plating rate of at least 2 µm/h is usually required for practical applications.

Determination of thickness of the metal or metal allov deposits: The deposit thickness was measured at 10 positions of each substrate and is used to determine the layer thickness by XRF using the XRF instrument Fischerscope XDV-SDD (Helmut Fischer GmbH, Germany). By assuming a layered structure of the deposit, the layer thickness can be calculated from such XRF data. Alternatively, the thickness of deposits was determined from a frequency change in a quartz crystal with a quartz crystal microbalance (SRS QCM200, Stanford Research Systems, Inc.).

Measurements of plating rate: The plating rate was obtained by dividing the thickness of the tin deposit by the time necessary to obtain said thickness.

pH values were measured with a pH meter (SevenMulti S40 professional pH meter, electrode: InLab Semi-Micro-L, Mettler-Toledo GmbH, ARGENTHALTM with Ag⁺-trap, reference electrolyte: 3 mol/L KCI) at 25 °C. The measurement was continued until the pH value became constant, but in any case at least for 3 min. The pH meter was calibrated with three standards for high pH values at 7.00, 9.00 and 12.00 supplied by Merck KGaA prior to use.

### Inventive example 1: Sodium sulfite as accelerator in an electroless tin plating bath

In a beaker 660.66 g potassium pyrophosphate was dissolved in deionized water and 220 g titanium(III)chloride was added to the solution and dissolved while the solution was stirred. The volume of the resulting solution was adjusted to 1000 mL with deionized water.

The resulting solution was stirred at 60 °C for two to three hours until a dark blue solution with a precipitate is formed. The solution was filtered (10 µm) and the titanium concentration was determined via titration. The titanium concentration should usually be in the range of 190 to 215 mM. The resulting solution has a pH value of about 7.8 - 8.3

The solution described above was used to prepare an inventive tin plating bath comprising the following components:

| | |
|---|---|
| c (Sn²⁺) | = 60 mmol/L |
| c (Ti³⁺) | = 60 mmol/L |
| c (pyrophosphate) | = 700 mmol/L |
| c (2-mercaptopyridine) | = 20 mmol/L |
| sodium hypophosphite | = 5 g/L |
| sodium sulfite | = 30 ppm |
| pH | = 8.2 |
| Temperature | = 75 °C |

Circuit boards were coated with Cu as substrate 5 x 5 cm = 25 cm² and BGA structures coated with 150 µm diameter and the following Sn layer thicknesses were measured with the XRF. The results are summarized in Table I.

The tin plating bath was stable and shows no precipitations or plate out.

### Inventive example 2: Sulfur as accelerator in an electroless tin plating bath

The method described for inventive example 1 was repeated but sodium sulfite was substituted with 1 ppm sulfur nano particles with an aerodynamic diameter determined via an aerodynamic particle sizer (APS) below 100. The results are summarized in Table I.

The tin plating bath was stable and shows no precipitations or plate out.

### Inventive example 3: Sodium dithionit as accelerator in an electroless tin plating bath

The method described for inventive example 1 was repeated but sodium sulfite was substituted with 20 ppm sodium dithionite. Only BGA structures were plated during this example. The results are summarized in Table I.

The tin plating bath was stable and shows no precipitations or plate out.

### Inventive example 4: Sodium thiosulfate as accelerator in an electroless tin plating bath

The method described for inventive example 1 was repeated but the inventive tin plating bath comprised the following components:

| | |
|---|---|
| c (Sn²⁺) | = 50 mmol/L |
| c (Ti³⁺) | = 60 mmol/L |
| c (pyrophosphate) | = 700 mmol/L |
| c (2-mercaptopyridine) | = 0 mmol/L (none) |
| sodium hypophosphite | = 5 g/L |
| sodium thiosulfate | = 150 ppm |
| pH | = 8.0 |
| Temperature | = 75 °C |

The tin plating bath was stable and shows no precipitations or plate out.

Only BGA structures were plated during this example. The results are summarized in Table I.

### Inventive example 5: Sodium dithionite as accelerator in an electroless tin plating bath

The method described for inventive example 1 was repeated but the inventive tin plating bath comprised the following components:

| | |
|---|---|
| c (Sn²⁺) | = 50 mmol/L |
| c (Ti³⁺) | = 60 mmol/L |
| c (pyrophosphate) | = 700 mmol/L |
| c (2-mercaptopyridine) | = 0 mmol/L (none) |
| sodium hypophosphite | = 5 g/L |
| sodium dithionite | = 100 ppm |
| pH | = 8.0 |
| Temperature | = 75 °C |

The tin plating bath was stable and shows no precipitations or plate out.

Only BGA structures were plated during this example. The results are summarized in Table I.

### Inventive example 6: Sodium sulfite as accelerator in an electroless tin plating bath

The method described for inventive example 1 was repeated but the inventive tin plating bath comprised the following components:

| | |
|---|---|
| c (Sn²⁺) | = 50 mmol/L |
| c (Ti³⁺) | = 60 mmol/L |
| c (pyrophosphate) | = 700 mmol/L |
| c (2-mercaptopyridine) | = 0 mmol/L (none) |
| sodium hypophosphite | = 5 g/L |
| sodium sulfite | = 150 ppm |
| pH | = 8.0 |
| Temperature | = 75 °C |

The tin plating bath was stable and shows no precipitations or plate out.

Only BGA structures were plated during this example. The results are summarized in Table I.

### Inventive example 7: Sodium sulfite as accelerator in an electroless tin plating bath

The method described for inventive example 1 was repeated but the inventive tin plating bath comprised the following components:

| | |
|---|---|
| c (Sn²⁺) | = 60 mmol/L |
| c (Ti³⁺) | = 50 mmol/L |
| c (1-hydroxyethane 1,1-diphosphonic acid (HEDP)) | = 600 mmol/L |
| c (2-mercaptopyridine) | = 0 mmol/L (none) |
| sodium sulfite | = 20 ppm |
| pH | = 8.2 |
| Temperature | = 75 °C |

Circuit boards were coated with Cu as substrate 5 x 5 cm = 25 cm² and BGA structures coated with 150 µm diameter and the following Sn layer thicknesses were measured with the XRF. The results are summarized in Table I.

The tin plating bath was stable and shows no precipitations or plate out.

### Inventive example 8: Sulfur as accelerator in an electroless tin plating bath

The method described for inventive example 1 was repeated but the inventive tin plating bath comprised the following components:

| | |
|---|---|
| c (Sn2+) | = 60 mmol/L |
| c (Ti3+) | = 60 mmol/L |
| c (potassium pyrophosphate) | = 720 mmol/L |
| c (sodium hypophosphite) | = 56 mmol/L |
| sulfur nano particles | = a spatula tip of sulfur nano particles |
| pH | = 8.2 |
| Temperature | = 75 °C |

The used sulfur nano particles had an aerodynamic diameter determined via an aerodynamic particle sizer (APS) below 100.

Only BGA structures were plated during this example. The results are summarized in Table I.

The tin plating bath was stable and shows no precipitations or plate out.

### Inventive example 9: Sodium tetrathionate as accelerator in an electroless tin plating bath

The method described for inventive example 1 was repeated but the inventive tin plating bath comprised the following components:

| | |
|---|---|
| c (Sn2+) | = 50 mmol/L |
| c (Ti3+) | = 60 mmol/L |
| c (potassium pyrophosphate) | = 700 mmol/L |
| c (sodium hypophosphite) | = 5 g/L |
| sodium tetrathionate | = 50 ppm |
| pH | = 8.0 |
| Temperature | = 75 °C |

Only BGA structures were plated during this example. The results are summarized in Table I.

The tin plating bath was stable and shows no precipitations or plate out.

### Inventive example 10: Sodium disulfite as accelerator in an electroless tin plating bath

The method described for inventive example 1 was repeated but the inventive tin plating bath comprised the following components:

| | |
|---|---|
| c (Sn2+) | = 50 mmol/L |
| c (Ti3+) | = 60 mmol/L |
| c (potassium pyrophosphate) | = 700 mmol/L |
| c (sodium hypophosphite) | = 5 g/L |
| sodium disulfite | = 20 ppm |
| pH | = 8.0 |
| Temperature | = 75 °C |

Only BGA structures were plated during this example. The results are summarized in Table I.

The tin plating bath was stable and shows no precipitations or plate out.

### Inventive example 11: Sodium sulfite as accelerator in an electroless tin plating bath

The method described for inventive example 1 was repeated but the inventive tin plating bath comprised the following components:

| | |
|---|---|
| c (Sn²⁺) | = 60 mmol/L |
| c (Ti³⁺) | = 50 mmol/L |
| c (sodium hypophosphite) | = 5 g/L |
| sodium sulfite | = 5 ppm |
| ammonia (15 % per weight) | = 1.5 mL/L |
| pH | = 8.2 |
| Temperature | = 70 °C |

Circuit boards were coated with Cu as substrate 5 x 5 cm = 25 cm² and BGA structures coated with 150 µm diameter and the following Sn layer thicknesses were measured with the XRF. The results are summarized in Table I.

The tin plating bath was stable over 8 hours while the deposition rate was constant at about 5 µm/h over this time. No precipitations or plate out took place.

### Inventive example 12: Ammonium sulfide as accelerator in an electroless tin plating bath

The method described for inventive example 1 was repeated but the inventive tin plating bath comprised the following components:

| | |
|---|---|
| c (Sn2+) | = 50 mmol/L |
| c (Ti3+) | = 60 mmol/L |
| c (potassium pyrophosphate) | = 700 mmol/L |
| c (sodium hypophosphite) | = 5 g/L |
| c (2-mercaptopyridine) | = 20 mmol/L |
| ammonium sulfide | = 3 ppm |
| pH | = 8.0 |
| Temperature | = 70 °C |

Circuit boards were coated with Cu as substrate 5 x 5 cm = 25 cm² and BGA structures coated with 150 µm diameter and the following Sn layer thicknesses were measured with the XRF. The results are summarized in Table I. The tin plating bath was stable and shows no precipitations or plate out.

### Inventive example 13: Ammonium sulfide as accelerator in an electroless tin plating bath

The method described for inventive example 1 was repeated but the inventive tin plating bath comprised the following components:

| | |
|---|---|
| c (Sn2+) | = 50 mmol/L |
| c (Ti3+) | = 60 mmol/L |
| c (potassium pyrophosphate) | = 700 mmol/L |
| c (sodium hypophosphite) | = 5 g/L |
| c (2-mercaptopyridine) | = 20 mmol/L |
| sodium sulfide | =3 ppm |
| pH | = 8.0 |
| Temperature | = 70 °C |

Circuit boards were coated with Cu as substrate 5 x 5 cm = 25 cm² and BGA structures coated with 150 µm diameter and the following Sn layer thicknesses were measured with the XRF. The results are summarized in Table I. The tin plating bath was stable and shows no precipitations or plate out.

### Comparative example C1: no accelerator in an electroless tin plating bath

The method described for inventive example 1 was repeated but sodium sulfite or sulfur was omitted. Thus, no sulfite and dithionite and sulfur were used in this example.

The tin plating bath was stable and shows no precipitations or plate out. The results of all examples are summarized in Table I.

### Comparative example C2: no accelerator in an electroless tin plating bath

The method described for inventive example 8 was repeated but 2-mercaptopyridine (40mM) was used instead of the sulfur nano particles. Thus, no sulfite and dithionite and sulfur were used in this example. No BGA structures were plated during this example.

The tin plating bath was stable and shows no precipitations or plate out. The results of all examples are summarized in Table I.

**Table I: Tin deposit thickness in dependence of accelerator.**

| # | accelerator | thickness of tin deposit [µm/h] 25cm2 | thickness of tin deposit [µm/h] BGA |
|---|---|---|---|
| C1 | Comparative example 1: no accelerator | 2.3 | 0 |
| C2 | Comparative example 1: no accelerator | 2.5 | 0 |
| 1 | Inventive example 1: sodium sulfite | 4.8 | 5.2 |
| 2 | Inventive example 2: sulfur | 4.5 | 5.0 |
| 3 | Inventive example 3: Sodium dithionite | - | 5.0 |
| 4 | Inventive example 4: Sodium thiosulfate | - | 7.2 |
| 5 | Inventive example 5: Sodium dithionite | - | 4.8 |
| 6 | Inventive example 6: Sodium sulfite | - | 6.0 |
| 7 | Inventive example 7: Sodium sulfite | 5.0 | 4.8 |
| 8 | Inventive example 8: sulfur | 5.0 | - |
| 9 | Inventive example 9: sodium tetrathionate | - | 5.8 |
| 10 | Inventive example 10: sodium disulfite | - | 4.7 |
| 11 | Inventive example 11: sodium sulfite | 3.0 | 5.0 |
| 12 | Inventive example 12: ammonium sulfide | 3.0 | 5.0 |
| 13 | Inventive example 13: sodium sulfide | 3.0 | 5.0 |

The tin deposits obtained from inventive examples 1 to 13 were glossy and free of visually detectable defects such as blisters, burnings and the like. The tin deposits obtained from inventive examples 1, 3 to 7, 9 and 10 to 13 were slightly better than tin deposits obtained from inventive example 2 and 8.

By using of at least one accelerator selected from the group consisting of sulfites, dithionites, thiosulfates, elemental sulfur and mixtures thereof in the electroless tin plating bath, the plating rate was significantly improved compared to comparative examples C1 and C2.

## Claims

1. An electroless tin plating bath comprising
(a) tin ions;
(b) titanium ions as reducing agent suitable to reduce tin ions to metallic tin;
(c) at least one accelerator selected from the group consisting of sulfites, dithionites, thiosulfates, tetrathionates, polythionates, disulfites, sulfides, disulfide, polysulfide, elemental sulfur and mixtures thereof;
(d) at least one complexing agent; and
(e) optionally at least one hypophosphite,
wherein the pH value of the tin plating bath is from 5 to 10.5 with the proviso if thiosulfates are comprised in the tin plating bath the pH upper value is lower than 9.5.

2. The tin plating bath according to claim 1, wherein the accelerator(s) is/are selected from the group consisting of alkaline metal sulfites, alkaline metal hydrogen sulfites, alkaline earth metal sulfites, alkaline earth metal hydrogen sulfites, ammonium sulfite, ammonium hydrogen sulfite, alkaline metal dithionites, alkaline metal hydrogen dithionites, alkaline earth metal dithionites, alkaline earth metal hydrogen dithionites, alkaline metal thiosulfates, alkaline metal hydrogen thiosulfates, alkaline earth metal thiosulfates, alkaline earth metal hydrogen thiosulfates, ammonium thiosulfate, ammonium hydrogen thiosulfate, alkaline metal tetrathionates, alkaline metal hydrogen tetrathionates, alkaline earth metal tetrathionates, alkaline earth metal hydrogen tetrathionates, ammonium tetrathionates, ammonium hydrogen tetrathionate, alkaline metal polythionates, alkaline metal hydrogen polythionates, alkaline earth metal polythionates, alkaline earth metal hydrogen polythionates, ammonium polythionates, ammonium hydrogen polythionate, alkaline metal disulfites, alkaline metal hydrogen disulfites, alkaline earth metal disulfites, alkaline earth metal hydrogen disulfites, ammonium disulfites, ammonium hydrogen disulfite, alkaline metal sulfide, alkaline metal disulfide, alkaline metal polysulfide, ammonium sulfide, and cyclo-octasulfur (S₈).

3. The tin plating bath according to claim 1 or 2, wherein the accelerator(s) is/are selected from the group consisting of sodium sulfite, potassium sulfite, sodium hydrogen sulfite (sodium bisulfite), potassium hydrogen sulfite (potassium bisulfite), calcium dihydrogen disulfite (calcium bisulfite), magnesium dihydrogen disulfite (magnesium bisulfite), ammonium sulfite, ammonium hydrogen sulfite, sodium dithionite, potassium dithionite, calcium dithionite, magnesium dithionite, sodium thiosulfate, sodium hydrogen thiosulfate, potassium thiosulfate, calcium thiosulfate, potassium thiosulfate, barium thiosulfate, ammonium thiosulfate, ammonium hydrogen thiosulfate, sodium tetrathionate, potassium tetrathionate, ammonium tetrathionate, ammonium hydrogen tetrathionate, barium tetrathionate, sodium polythionate, potassium polythionate, ammonium polythionate, ammonium hydrogen polythionate, sodium disulfite, potassium disulfite, ammonium disulfite, ammonium hydrogen disulfite, sodium or pottasium sulfide, sodium or pottasium disulfide, sodium or pottasium polysulfide, ammonium sulfide, and particulate cyclo-octasulfur (S₈).

4. The tin plating bath according to any one of the preceding claims, wherein the total amount by weight of the accelerator(s) in the tin plating bath ranges from 0.01 to 300 ppm, preferably from 0.1 to 200 ppm, and more preferably from 0.5 to 175 ppm.

5. The tin plating bath of one or more of the preceding claims, wherein the at least one complexing agent is selected from the group consisting of
- organic polycarboxylic acids, their salts, anhydrides and esters,
- organic phosphonic acids, their salts and esters,
- organic polyphosphoric acids, their salts and esters, and
- inorganic polyphosphoric acids, their salts and esters.

6. The tin plating bath according to claim 5, wherein the organic polycarboxylic acids, their salts and esters, are selected from the group consisting of oxalic acid, tartaric acid, citric acid, nitrilotriacetic acid, ethylenediaminetetraacetic acid, dimercaptosuccinic acid, 1,4,7,10-tetraazacyclododecane-1,4,7,10-tetraacetic acid, 3,6,9,12-Tetrakis(carboxymethyl)-3,6,9,12-tetraazatetradecane-1,14-dioic acid, pentetic acid, iminodiacetic acid, diethylenetriamine, aminoethylethanolamine, and salts or esters thereof.

7. The tin plating bath according to claim 5 or 6, wherein the organic phosphonic acid compound, its salts and esters are selected from the group consisting of 1-Hydroxyethane 1,1-diphosphonic acid, its salts and esters, Aminotris(methylenephosphonic acid), its salts and esters, Diethylenetriamine penta(methylene phosphonic acid), its salts and esters, Ethylenediamine tetra(methylenephosphonic acid), its salts and esters, Phosphonobutane tricarboxylic acid, its salts and esters, Hexanediamine tetra(methylenephosphonic acid), its salts and esters, Hydroxyethylamino di(methylenephosphonic acid), its salts and esters, and Bis(hexamethylene) triamine-pentakis(methylphosphonic acid), its salts and esters.

8. The tin plating bath according to any one of the claims 5 to 7, wherein the inorganic polyphosphoric acid is selected from the group consisting of potassium pyrophosphate, sodium pyrophosphate, and hydrogen sodium pyrophosphate.

9. The tin plating bath according to any one of the claims 5 to 8, wherein the organic and/or inorganic polyphosphoric acid compound, its salts and esters, comprise 2 to 10 phospho-building units linked together, preferably 2 to 5, more preferably 2 or 3.

10. The tin plating bath according to any one of the preceding claims **characterized in that**
A) the total concentration of all tin ions ranges from 0.02 to 0.2 mol/L, more preferably from 0.04 to 0.15 mol/L and even more preferably from 0.05 to 0.08 mol/L
and/or
B) the total concentration of all titanium ions ranges from 0.02 mol/L to 0.2 mol/L, more preferably from 0.04 mol/L to 0.15 mol/L and even more preferably from 0.05 to 0.08 mol/L.

11. The tin plating bath according to any one of the preceding claims **characterized in that** the tin plating bath is free of organic sulfites.

12. The tin plating bath according to any one of the preceding claims **characterized in that** the pH value of the tin plating bath is from 5 to 9.

13. The tin plating bath according to any one of the preceding claims further comprising
(f) at least one stabilizing additive selected from the group consisting of 2-mercaptopyridine, 2-mercaptobenzothiazole, 2-mercapto-2-thiazoline and mixtures of the aforementioned.

14. Use of the tin plating bath according to any one of claims 1 to 13 for depositing tin or tin alloy onto at least one surface of a substrate.

15. Method for depositing tin or tin alloy onto at least one surface of a substrate comprising the method steps
(i) providing the substrate; and
(ii) contacting the at least one surface of the substrate with the tin plating bath according to any one of the claims 1 to 13 such that a tin or tin alloy is deposited on the at least one surface of the substrate.
